# EUROPEAN PATENT APPLICATION

(11) **EP 1 610 608 A1**
(43) Date of publication of application: **28.12.2005**
(21) Application number: 03816551.0
(22) Date of filing: 10.11.2003
(51) Int. Cl.: H05K 9/00, H01F 1/00, H01F 1/34, C04B 35/26, C01G 49/00

(54) **SiC-HEXAGONAL FERRITE TYPE CERAMIC COMPOSITE ELECTROMAGNETIC WAVE ABSORBER**

(30) Priority: 31.03.2003 JP 2003097022
(71) Applicant: Japan Science and Technology Agency, Kawaguchi-shi, Saitama 332-0012 (JP)
(72) Inventor: Takada, Jun, Okayama-shi, Okayama 703-8243 (JP); Fujii, Tatsuo, Okayama-shi, Okayama 700-0085 (JP); Nakanishi, Makoto, Okayama-shi, Okayama 700-0011 (JP)
(74) Representative: Emde, Eric
(86) International application number: PCT/JP2003/014280
(87) International publication number: WO 2004/089054

(57) **Abstract**

A SiC-hexagonal ferrite type ceramic composite electromagnetic wave absorber for a high-frequency band, the electromagnetic wave absorber **characterized by** being composed of a composite sintered product of a hexagonal ferrite and SiC. The electromagnetic wave absorber is produced by a method including the steps of incorporating 1 to 5 percent by weight of SiC powder or fiber into a hexagonal ferrite together with a sintering additive, followed by molding and, thereafter, conducting sintering at 700°C to 900°C, or a method including the steps of incorporating 1 to 5 percent by weight of curing-treated SiC precursor into a hexagonal ferrite, followed by molding and, thereafter, conducting sintering.

## Description

### Technical Field

The present invention relates to an electromagnetic wave absorber which is composed of a composite sintered product of a hexagonal ferrite and SiC, and which exhibits high absorption over a wide band in a high-frequency band (GHz band).

### Background Art

In recent years, frequencies used for wireless LANs, intelligent transport systems (ITS), next-generation cellular phones, and the like have been changed from a MHz band to a GHz band in which high-speed and high-volume information transmission can be conducted.

In this band, carbon-containing resins and the like are primarily used for electromagnetic wave absorbers to prevent malfunctions of equipment at present. However, the width of the absorption band is narrow, and there are heat resistance and other problems.

A spinel ferrite is also used for an electromagnetic wave absorber. However, it is difficult to use this in the GHz band because of a snake phenomenon (natural resonance occurs in the neighborhood of 1 GHz and, thereby, no absorption is effected in a high-frequency region higher than that).

The inventors of the present invention previously found that a composite sintered product of a spinel ferrite and SiC is effective as an electromagnetic wave absorber in the GHz band (the absorption in the GHz band is based on SiC), and filed an application for a patent (Non-Patent Document 1 and Patent Document 1).

This composite sintered product is produced by combining a spinel ferrite (absorption frequency is a few hundred megahertz) that is a magnetic loss material and SiC (absorption frequency is 10 GHz or more) that is a dielectric loss material. However, only the magnetic loss is manifested, and there is a problem in that although the absorption frequency is increased up to the GHz band, the absorption width is narrow.

It is also known that the hexagonal ferrite serves as an electromagnetic wave absorber in the GHz band (Non-Patent Documents 2 to 4). The resonant frequency of M-type BaFe₁₂O₁₉ is 50 GHz. The resonant frequency of Ba[Fe₁₂₋ₓ(Ti_{0.5}Mn_{0.5})ₓ]O₁₉ in which Ti and Mn have substituted for Fe is 16 GHz where the amount of substitution x = 2.5, and the resonant frequency is 6 GHz where x = 4.5. The resonant frequency of Ferroxplana-type Ba₂Co₂Fe₁₂O₂₂ (Y type) is 5 to 10 GHz, and the resonant frequency of Ba₃Co₂Fe₂₄O₄₁ (Z type) is 1 GHz. There are also problems in that, for example, the width of the absorption band is small.
Non-Patent Document 1 J. Takada et al., "Pureseramikkusuhou niyoru feraitokei hukugouzairyono sakuseito denpakyusyutokusei (Preparation of ferrite composite material by pre-ceramics method and wave absorption characteristics)", J. Magn. Soc. Jpn., Vol. 26, No. 6, p818-822 (2002)
Non-Patent Document 2 M. Hanazawa et al., "M-gata roppousyo feraitoo mochiita 40 GHz taiyo denpakyusyutaino koutaiikikani kansuru kentou (Study on band-widening of 40-GHz-band wave absorber including M-type hexagonal ferrite)", Denshijouhou tsuushingakkai taikaikouen ronbunsyu (Proceedings of IEICE Conference), Vol. 2002, Tsuushin (Communication) 1 PAGE, 384 (2002)
Non-Patent Document 3 T. Inui et al., "Roppousyo Mg₂Y feraitoo mochiita koutaiiki denpakyusyutai (Wide-band wave absorber including hexagonal Mg₂Y ferrite)", Denshijouhou tsuushingakkai taikaikouen ronbunsyu (Proceedings of IEICE Conference), Vol. 1999, Sougou (General) 2 PAGE, 340 (1999) Non-Patent Document 4 H. Ota et al., "M-gata roppousyo feraito hukugoutai shitono hukusotoujiritsuto denpakyusyutokusei (Complex magnetic permeability and wave absorption characteristics of M-type hexagonal ferrite composite sheet)", Denshijouhou tsuushingakkai taikaikouen ronbunsyu (Proceedings of IEICE Conference), Vol. 2000, Sougou (General) 2 PAGE, 728-729 (2000)
Patent Document 1 Japanese Unexamined Patent Application Publication No. 2002-37662

### Disclosure of Invention

The inventors of the present invention found that an electromagnetic wave absorber exhibiting a high amount of absorption over a wide frequency range in the GHz band was able to be provided by composite-sintering a hexagonal ferrite and electrically conductive SiC.

That is, the present invention relates to (1) a SiC-hexagonal ferrite type ceramic composite electromagnetic wave absorber for a high-frequency band, the electromagnetic wave absorber characterized by being composed of a composite sintered product of a hexagonal ferrite and SiC.

The present invention relates to (2) the electromagnetic wave absorber according to the above-described item (1), characterized in that SiC is produced by incorporating 1 to 5 percent by weight of SiC powder or fiber into the hexagonal ferrite.

The present invention relates to (3) the electromagnetic wave absorber according to the above-described item (1), characterized in that SiC is produced by incorporating 1 to 5 percent by weight of curing-treated SiC precursor into the hexagonal ferrite.

The present invention relates to (4) the electromagnetic wave absorber according to any one of the above-described items (1) to (3), characterized in that the hexagonal ferrite is of Y-type or Z-type.

The present invention relates to (5) the electromagnetic wave absorber according to any one of the above-described items (1) to (3), characterized in that the hexagonal ferrite is Ba₂Ni₂Fe₁₂O₂₂ or Ba₃Co₂Fe₂₄O₄₁.

The present invention relates to (6) a method for producing the electromagnetic wave absorber according to the above-described item (2), the method characterized by including the steps of incorporating 1 to 5 percent by weight of SiC powder or fiber into a hexagonal ferrite together with a sintering additive, followed by molding, and conducting sintering at 700°C to 900°C.

The present invention relates to (6) a method for producing the electromagnetic wave absorber according to the above-described item (3), the method characterized by including the steps of incorporating 1 to 5 percent by weight of curing-treated SiC precursor into a hexagonal ferrite, followed by molding, and conducting sintering.

The ferrite is a generic name for magnetic oxides containing Fe₂O₃ as a primary component, and a) a spinel ferrite, b) a hexagonal ferrite, c) garnet type, and d) perovskite type are included. The hexagonal ferrite is an iron oxide based magnetic material containing Ba and the like. The crystal structure is hexagonal, and ① Magnetoplumbite (M) type and ② Ferroxplana type (Y type, X type, Z type, W type, and U type) are included. Typical Ferroxplana type is the Y type or the Z type.

The composition of the hexagonal ferrite is shown by, for example, an equilibrium diagram of BaO-AO-Fe₂O₃. Here, Sr, Pb, or the like may substitutes for Ba in BaO. A divalent metal, Mg, Co, Ni, Cu, Zn, or the like is represented by A.

The electrically conductive SiC takes an action to absorb an electromagnetic wave only after the SiC is dispersed into an insulating material, e.g., a hexagonal ferrite. The absorption wavelength of SiC varies depending on the production history of SiC. The absorption wavelength is about 8 GHz when SiC originates from an inorganic polymer, polycarbosilane (PCS), and is about 10 GHz when a SiC powder is incorporated.

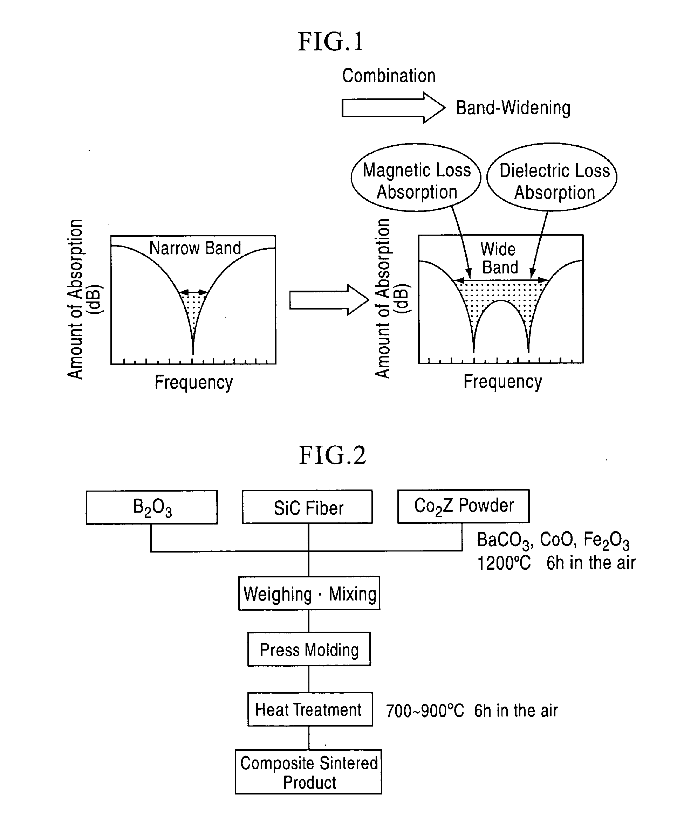

As described above, the ferrite exhibits electromagnetic wave absorption based on the magnetic loss, and SiC exhibits electromagnetic wave absorption based on the dielectric loss. The inventors of the present invention combined the two, and succeeded in realization of an electromagnetic wave-absorbing composite sintered product having a wide absorption width and a high amount of absorption in the GHz band while taking advantage of the magnetic loss and the dielectric loss in combination. Fig. 1 shows the concept of band-widening taking advantage of the magnetic loss and the dielectric loss in combination.

For example, Ba₂Ni₂Fe₁₂O₂₂ (denoted as Ni₂Y in the present specification) or Ba₃Co₂Fe₂₄O₄₁ (denoted as Co₂Z in the present specification) is used as the hexagonal ferrite. The electromagnetic wave absorption region can be variously changed in the GHz region by selecting the composition of the hexagonal ferrite and SiC. For example, a composite in which a few percent by weight of SiC has been incorporated into a Y-type hexagonal ferrite exhibits electromagnetic wave absorption double peaks at 7 GHz and 11 GHz (the former is based on the hexagonal ferrite magnetic loss, and the latter is based on the SiC dielectric loss). The absorption width at the amount of absorption of -15 dB is 6 GHz and, therefore, the composite has a wide absorption width and a high amount of absorption.

This composite sintered product can be produced by ① incorporating a small amount of SiC powder or fiber into the hexagonal ferrite and conducting low-temperature sintering together with a sintering additive (a low-temperature sintering method), or ② incorporating a small amount of curing-treated SiC precursor into the hexagonal ferrite and conducting sintering (a pre-ceramics method). The low-temperature sintering method of item ① is a preferable production method since it can be applied to every hexagonal ferrite. The pre-ceramics method of item ② can be applied to limited hexagonal ferrites.

### Brief Description of the Drawings

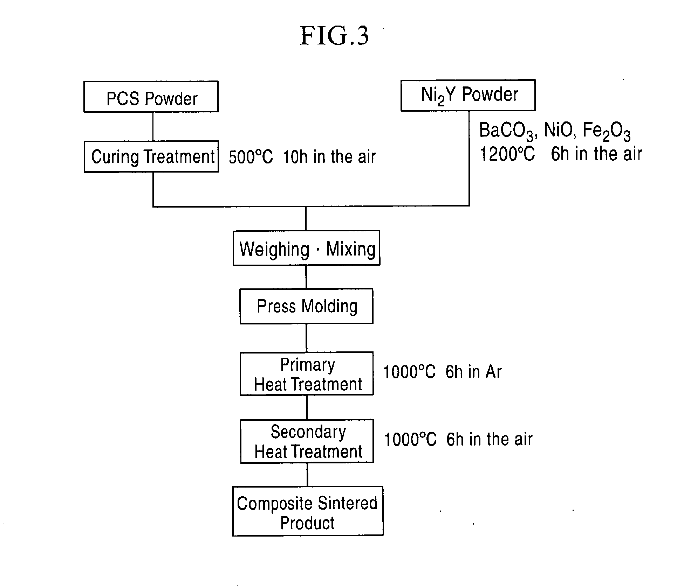

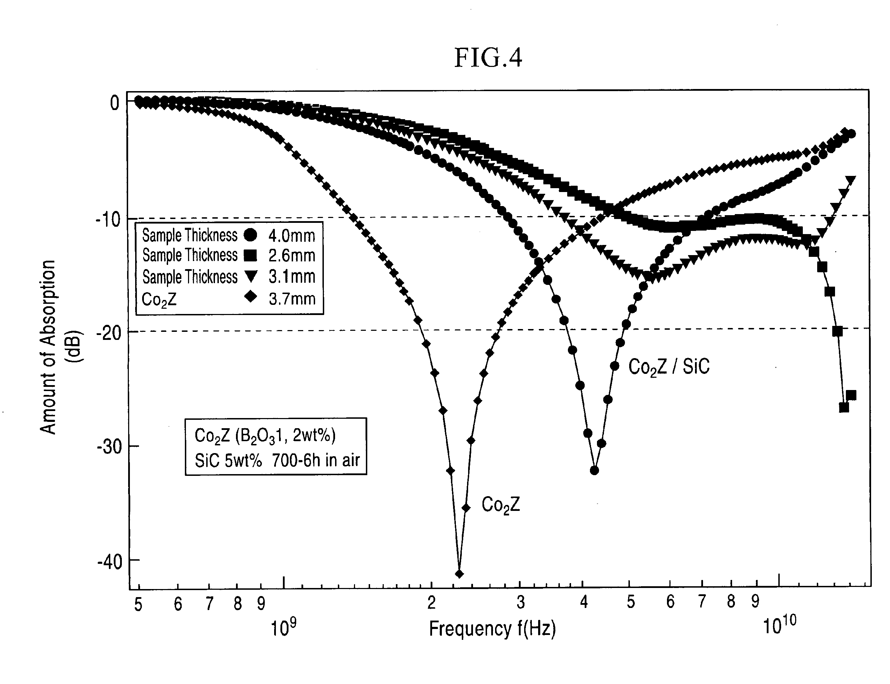

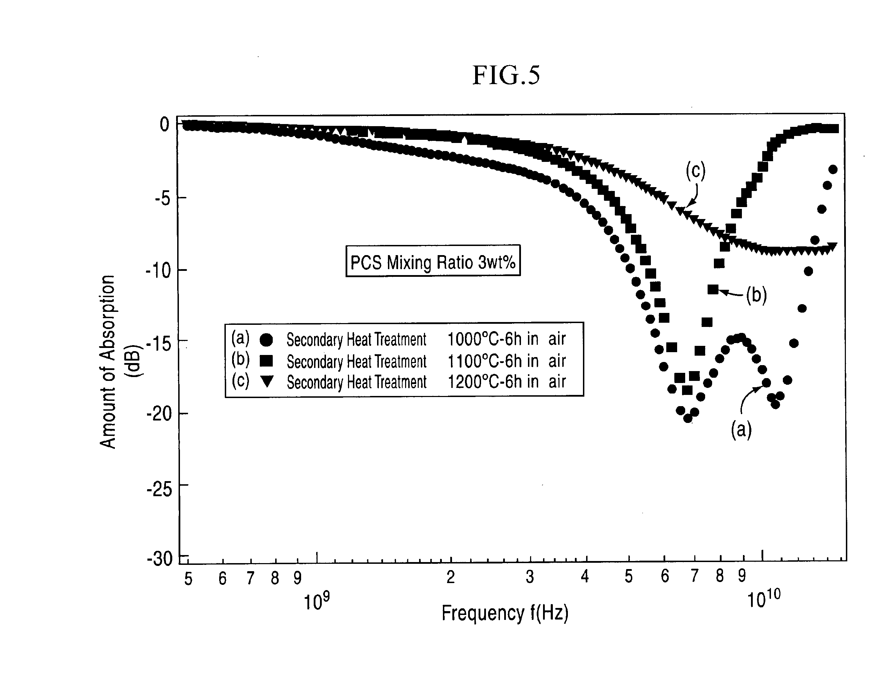

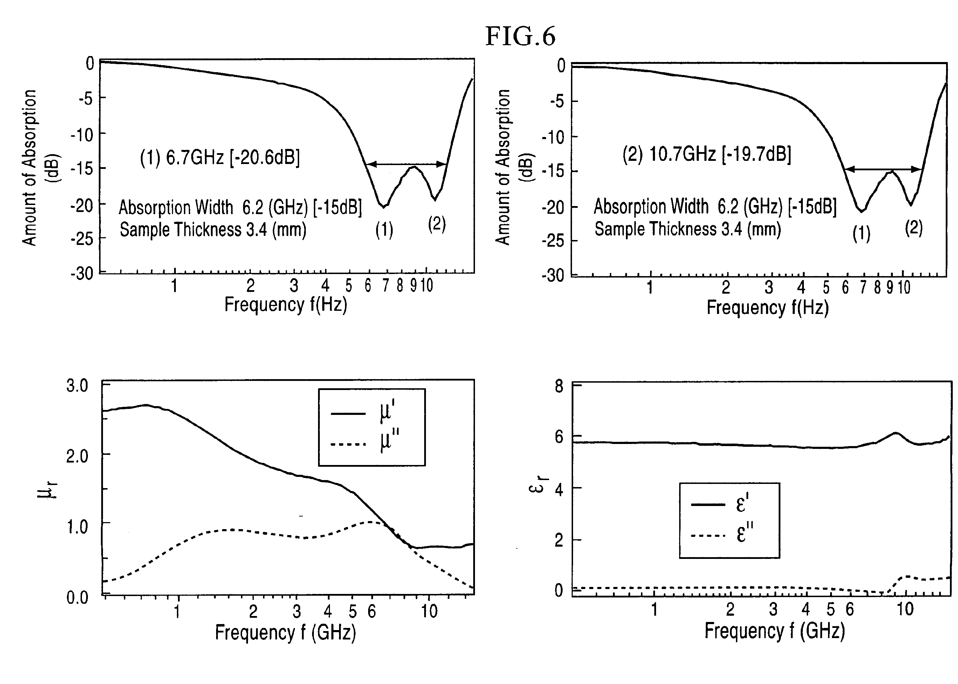

Fig. 1 is a conceptual diagram showing that band-widening is intended by combining different materials to take advantage of the magnetic loss and the dielectric loss in combination. Fig. 2 is a flow chart of a low-temperature sintering method to produce the electromagnetic wave absorber of the present invention. Fig. 3 is a flow chart of a pre-ceramics method to produce the electromagnetic wave absorber of the present invention. Fig. 4 is a graph showing the electromagnetic wave absorption characteristics of sintered products produced in Example 1. Fig. 5 is a graph showing the electromagnetic wave absorption characteristics of sintered products produced in Example 2. Fig. 6 shows graphs of the measurement results of the complex magnetic permeability and the complex dielectric constant of the sintered product produced in Example 2.

### Best Mode for Carrying Out the Invention

### ① Low-temperature sintering method

Fig. 2 shows a flow chart of a typical low-temperature sintering method.

A high-temperature heat treatment is required to produce a sintered composite of a hexagonal ferrite, e.g., Ni₂Y, and SiC. As the temperature is increased, Ba reacts with Si, and the composition is shifted, so that the characteristics of the ferrite are deteriorated. Therefore, a sintering additive is used and low-temperature sintering is conducted. Preferably, the sintering additive is B₂O₃. However, other sintering auxiliaries may be used as long as they are metal oxides, e.g., Bi₂O₃, PbO, and V₂O₅, and they can facilitate composite-sintering of the hexagonal ferrite and SiC. The additive is specified to be 0.2 to 10 percent by weight, and preferably be 1 to 5 percent by weight. The sintering temperature depends on types of the hexagonal ferrite and the sintering additive. If the sintering temperature is increased to 1,200°C, breakdown of the ferrite, reaction with the additive, and the like occur and, therefore, this is not preferable. The sintering temperature is preferably 700°C to 900°C in the air.

### ② Pre-ceramics method

Fig. 3 shows a flow chart of a typical pre-ceramics method.

Polycarbosilane (PCS), which is a silicon based ceramic-forming precursor (-SiHCH₃-CH₂-)ₙ, is curing-treated. The curing treatment is a treatment to form a SiO₂ film on the surface of a PCS powder, and the treatment method itself is a publicly known means (refer to the above-described Patent Document 1). That is, the curing treatment includes a thermal oxidation curing method in which a PCS surface is oxidized by a heat treatment conducted at a temperature range of about 200°C to 600°C in an oxidizing atmosphere, for example, in the air, for about 10 hours or more so as to form a SiO₂ oxide film and an electron beam curing method in which Si-Si bonds are formed by applying an electron beam or a γ ray to the PCS surface so as to form a film.

Preferably, the mixing ratio of PCS to Ba hexagonal ferrite is 1 to 30 percent by weight, and more preferably is 2 to 10 percent by weight. A primary heat treatment is conducted at 900°C to 1,200°C in an inert gas, and a secondary heat treatment is conducted at 900°C to 1,200°C, preferably in the neighborhood of 1,000°C, in the air.

### (EXAMPLES)

### EXAMPLE 1

A Ba ferrite (Co₂Z: Z type) powder was prepared as a raw material by mixing BaCo₃, CoO, and Fe₂O₃ at a ratio of Ba:Co:Fe = 3:2:24 and conducting sintering at 1,200°C for 6 hours. The resulting BaCo₂Z powder was mixed with 1 percent by weight of B₂O₃ (Sigma-Aldrich Japan K.K. SAJ analytical reagent grade: purity 90%) and 5 percent by weight of SiC fiber (SiC fiber produced by Nippon Carbon Co., Ltd.). The resulting mixed powder was press-molded into the shape of a pellet to prepare three samples, followed by sintering in the air at 700°C for 6 hours. The thicknesses of the three samples were 2.6 mm, 3.1 mm, and 4.0 mm, respectively. In addition, a sample of 3.7 mm in thickness was prepared as a comparative example by sintering a Co₂Z powder alone.

A composite sintered product of Co₂Z and the SiC fiber was produced through low-temperature sintering by using B₂O₃ as a sintering additive. The resulting sintered product was subjected to a powder X-ray diffraction measurement, texture observation with a scanning electron microscope (SEM), and a measurement of the amount of wave absorption with a network analyzer. Fig. 4 shows each of the electromagnetic wave absorption characteristics of the four samples. It was made clear that the sample of 3.1 mm in thickness had the dielectric loss and the magnetic loss in combination and exhibited absorption over a wide frequency range. Although the amount of absorption did not reach -20 dB of complete absorption, an absorption width of 6.8 GHz was exhibited at -10 dB.

### EXAMPLE 2

A Ba ferrite (Ni₂Y: Y type) powder was prepared as a raw material by mixing BaCo₃, NiO, and Fe₂O₃ at a ratio of Ba:Ni:Fe = 2:2:12 and conducting sintering in the air at 1,200°C for 6 hours. The resulting Ni₂Y powder was mixed with 3 percent by weight of curing-treated PCS. The curing treatment was conducted in the air at 500°C for 10 hours. The resulting mixed powder was press-molded into the shape of a pellet to prepare three samples, followed by primary sintering in an Ar atmosphere at 1,000°C for 6 hours. Thereafter, three samples were subjected to secondary sintering in the air at 1,000°C (a), 1,100°C (b), and 1,200°C (c), respectively, for 6 hours.

The resulting sintered products of three samples were subjected to the powder X-ray diffraction measurement, the texture observation with the scanning electron microscope (SEM), and the measurement of the amount of wave absorption with the network analyzer as in Example 1. Fig. 5 shows each of the electromagnetic wave absorption characteristics of (a), (b), and (c). The absorption characteristics became deteriorated as the secondary sintering temperature was increased. However, although the sample which had been subjected to the secondary sintering at 1,000°C did not reach -20 dB of complete absorption, an absorption width of 6.2 GHz was exhibited at -15 dB. It is clear from this that a preferable secondary sintering temperature is 1,000°C or less.

Fig. 6 shows the measurement results of the complex magnetic permeability (µr) and the complex dielectric constant (εr) of the sample which had been subjected to the secondary sintering at 1,000°C. It is clear from this that a composite sintered product having the magnetic loss and the dielectric loss in combination was produced.

### Industrial Applicability

In the advanced information and communications society expected to rapidly progress and develop in the future, electromagnetic wave absorbers in the GHz band become indispensable. Therefore, there is a high possibility of commercialization of the high-performance electromagnetic wave absorber for the GHz band according to the present invention.

## Claims

1. A SiC-hexagonal ferrite type ceramic composite electromagnetic wave absorber for a high-frequency band, the electromagnetic wave absorber **characterized by** comprising a composite sintered product of a hexagonal ferrite and SiC.

2. The electromagnetic wave absorber according to Claim 1, **characterized in that** SiC is produced by incorporating 1 to 5 percent by weight of SiC powder or fiber into the hexagonal ferrite.

3. The electromagnetic wave absorber according to Claim 1, **characterized in that** SiC is produced by incorporating 1 to 5 percent by weight of curing-treated SiC precursor into the hexagonal ferrite.

4. The electromagnetic wave absorber according to any one of Claim 1 to Claim 3, **characterized in that** the hexagonal ferrite is of Y-type or Z-type.

5. The electromagnetic wave absorber according to Claim 4, **characterized in that** the hexagonal ferrite is Ba₂Ni₂Fe₁₂O₂₂ or Ba₃Co₂Fe₂₄O₄₁.

6. A method for producing the electromagnetic wave absorber according to Claim 2, the method **characterized by** comprising the steps of incorporating 1 to 5 percent by weight of SiC powder or fiber into a hexagonal ferrite together with a sintering additive, followed by molding, and conducting sintering at 700°C to 900°C.

7. A method for producing the electromagnetic wave absorber according to Claim 3, the method **characterized by** comprising the steps of incorporating 1 to 5 percent by weight of curing-treated SiC precursor into a hexagonal ferrite, followed by molding, and conducting sintering.
